# EUROPÄISCHE PATENTSCHRIFT

(11) **EP 0 637 877 B1**
(45) Veröffentlichungstag und Bekanntmachung des Hinweises auf die Patenterteilung: **19.12.2001**
(21) Anmeldenummer: 94111415.9
(22) Anmeldetag: 21.07.1994
(51) Int. Cl.: H04B 5/00, G08C 17/04

(54) **Einrichtung zur berührungslosen Signal- und Energieübertragung**
Device for contactless transfer of signals and energy
Dispositif de transfert sans contact de signaux et d'énergie

(30) Priorität: 04.08.1993 DE 4326213
(43) Veröffentlichungstag der Anmeldung: 08.02.1995
(73) Patentinhaber: Infineon Technologies AG, 81669 München (DE)
(72) Erfinder: Reiner, Dipl.-Ing. Robert, D-82008 Unterhaching (DE)
(74) Vertreter: Zedlitz, Peter, Dipl.-Inf.

(56) Entgegenhaltungen:
- EP-A- 0 466 949
- DE-A- 3 029 543
- DE-A- 3 810 702
- FR-A- 2 500 944

## Beschreibung

Die Erfindung betrifft eine Einrichtung zur berührungslosen Signal- und Energieübertragung gemäß dem Oberbegriff des Anspruchs 1.

Eine derartige Einrichtung zur berührungslosen Signal- und Energieübertragung ist z.B. aus der EP-A-0 466 949 bekannt. Wesentlich bei einem derartigen System ist, daß eine derartige Einrichtung aus einem stationären Teil und einem Oszillator zur kontaktlosen Leistungsübertragung mit Hilfe von einem Spulenpaar an einen beweglichen Teil besteht, wobei die Schwingung des Oszillators in eine Bezugsschwingung und eine Informationsschwingung aufgespalten ist und der Informationsschwingung in Abhängigkeit von den zu übertragenden Daten eine Phasenverschiebung gegenüber der Bezugsschwingung aufgezwungen wird, wobei diese phasenverschobene Schwingung über ein erstes Spulenpaar und die Bezugsschwingung über ein zweites Spulenpaar dem beweglichen Teil zugeführt wird. Im beweglichen Teil werden die übertragenen Schwingungen einer Demodulatorschaltung zugeführt, die aus der Phasenverschiebung die Daten wiedergewinnt und eine Datenübertragung vom beweglichen Teil zum stationären Teil durch Belastungsänderung erfolgt, so daß die Leistungsübertragungen nur mit Hilfe eines Spulenpaares erfolgt und die Datenübertragung von dem beweglichen Teil zum stationären Teil nur durch Belastungsänderung der Spule des beweglichen Teils erfolgt, die nicht der Leistungsübertragung dient bzw. daß die Datenübertragung vom beweglichen Teil zum stationären Teil durch Belastungsänderung nur eines Spulenpaares erfolgt und daß die Leistungsübertragung nur mit Hilfe des Spulenpaares erfolgt, das momentan keine durch die Datenübertragung vom beweglichen Teil zum stationären Teil bedingte Belastungsänderung erfährt.

Aus der DE-A-38 10 702 ist insbesondere in Figur 1 der prinzipielle Aufbau einer ähnlichen Einrichtung zur kontaktlosen Signal- bzw. Energieübertragung dargestellt. Wie zu sehen ist, werden bei derartigen Anordnungen ein Quarzoszillator, mit Varicaps abgleichbare Schwingkreise, PLL-Filter und Phasenvergleicher benötigt, um den Energieübertragungskreis und den Datenübertragungskreis aufeinander und auf den Quarzoszillator abzugleichen.

Aufgabe der vorliegenden Erfindung ist es eine Einrichtung zur kontaktlosen Signal- bzw. Energieübertragung anzugeben, bei der die stationäre Station mit möglichst geringem technischen Aufwand realisiert werden kann.

Diese Aufgabe wird durch die kennzeichnenden Merkmale des Anspruchs 1 gelöst. Weiterbildungen sind Kennzeichen der Unteransprüche.

Vorteil der vorliegenden Erfindung ist es, daß auf den bei einer derartigen Anordnung bisher notwendigen Quarzoszillator verzichtet werden kann und stattdessen die Energiespule selbst als Oszillatorspule zu verwenden. Die Station arbeitet dann mit der Resonanzfrequenz der Energiespule, ohne daß dieser Kreis abgeglichen werden oder phasengeregelt werden muß.

Die Erfindung wird nachfolgend anhand zweier Figuren näher erläutert. Es zeigen
- Figur 1: ein Prinzipschaltbild einer erfindungsgemäßen Anordnung.
- Figur 2: ein Ausschnitt der in Figur 1 gezeigten Anordnung mit einer Erweiterung.

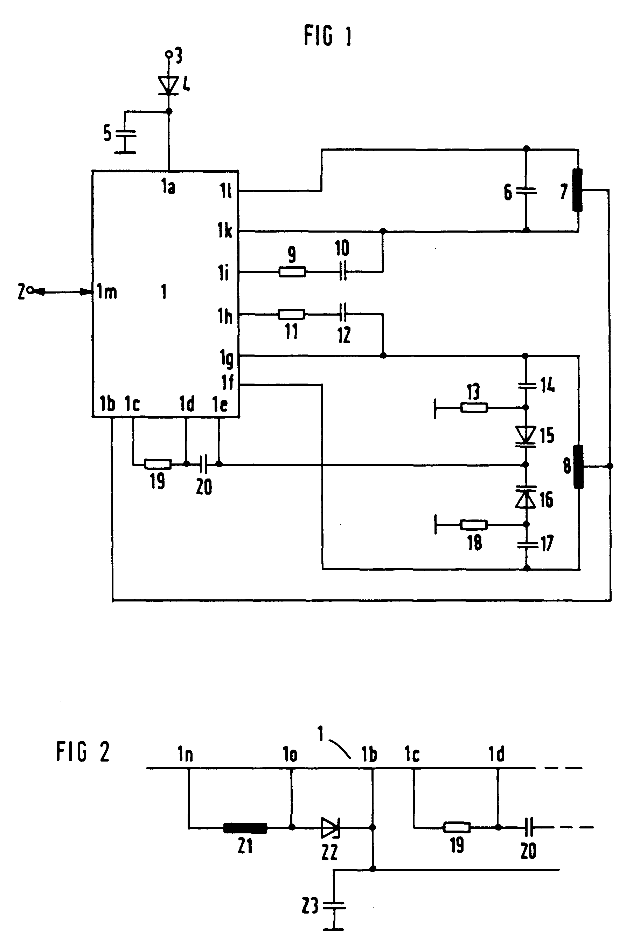

In Figur 1 ist eine Steuereinheit, z.B. ein integrierter Schaltkreis zur Steuerung eines kontaktlos arbeitenden Energie- und Datenübertragungssystems dargestellt. Mit 2 ist eine Eingangsklemme bezeichnet, an welcher digital die zu übertragenden oder zu empfangenden Daten abgreifbar sind. Diese ist mit einem Eingang 1m der Steuereinheit verbunden. Diese Schnittstelle kann entweder synchron oder asynchron je nach Verwendungszweck ausgelegt werden. Mit 1a ist ein Eingang zur Spannungsversorgung bezeichnet, welcher über eine Diode 4 mit einer Eingangsklemme 3 verbunden ist. Zusätzlich ist zwischen dem Eingang 1a und Masse eine Kapazität 5 geschaltet. Die Ausgänge 1l, 1k sind mit einer ersten Übertragungsspule 7 verbunden. Parallel zur Spule 7 ist eine Kapazität 6 geschaltet. Zwischen dem Eingang 1k und einem weiteren Eingang 1i befindet sich eine Reihenschaltung aus einer Kapazität 10 und einem Widerstand 9, die als Vorwiderstände zur Spannungsrückführung des Oszillators dienen. Selbstverständlich kann auch irgendeine andere Oszillatorschaltung eingesetzt werden. Desweiteren ist zwischen den Eingängen 1g und 1f eine zweite Übertragungsspule 8 geschaltet. Ebenso ist ein weiterer Eingang 1h vorgesehen, zwischen dem und dem Eingang 1g ebenfalls die Reihenschaltung aus einer Kapazität 12 und einem Widerstand 11 geschaltet ist. Dieser dient als Phasenmeßeingang für die zweite Übertragungsspule 8. Ein PLL-Filter ist vorgesehen, welches beispielsweise extern aus dem Widerstand 19 und der Kapazität 20 steht. Der Widerstand 19 ist zwischen Eingänge 1c und 1d und die Kapazität zwischen Eingänge 1d und 1e geschaltet. Die mit 8 bezifferte Übertragungsspule dient der Datenübertragung und weist einen Abgleichkreis auf, der beispielsweise aus einer Reihenschaltung einer ersten Kapazität 14, einer Kapazitätsdiode 15, sowie einer Kapazitätsdiode 16 und einer zweiten Kapazität 17 besteht. Diese Reihenschaltung ist parallel zur Spule 8 geschaltet. Dabei sind die Kapazitätsdioden 15 und 16 derart gegeneinander geschaltet, daß die Katoden miteinander verbunden sind. Der Knotenpunkt der Reihenschaltung der ersten Kapazität 14 und der Kapazitätsdiode 15 ist über einen Widerstand 13 mit Masse verschaltet. Ebenso ist der Knotenpunkt der Reihenschaltung der Kapazitätsdiode 16 und der zweiten Kapazität 17 über einen Widerstand 18 mit Masse verschaltet. Der Zusammenschluß der Katoden der beiden Kapazitätsdioden ist mit dem Ausgang 1e der Steuereinheit verbunden. Die beiden Spulen 7 und 8 weisen jeweils einen Mittelabgriff auf, der miteinander und mit einer weiteren Ausgangsklemme 1b verbunden ist. Am Ausgang 1b liegt eine Gleichspannung an.

Diese kann wie in Figur 2 dargestellt durch einen sogenannten Aufwärtswandler zusätzlich erhöht werden. Der Aufwärtswandler besteht beispielsweise aus zwei zusätzlichen externen Komponenten, der Spule 21 und einer Zenerdiode 22. Zusätzliche Ausgänge 1n und 1o sind vorgesehen. Die Spule 21 ist zwischen den zusätzlichen Ausgängen 1n und 1o geschaltet. Die Zenerdiode 22 ist derart zwischen die Ausgänge 1o und 1b geschaltet, daß die Katode mit dem Ausgang 1b in Verbindung steht. Zusätzlich ist ein Glättungskondensator 23 vorgesehen, der zwischen Ausgang 1b und Masse geschaltet ist.

In der in Figur 1 dargestellten erfindungsgemäßen Anordnung wird der Energiespulenkreis bestehend aus der Spule 7 und der Kapazität 6 als selbstschwingender Oszillator betrieben. Er dient dann selbst als Taktgeber für den mobilen Datenträger. Über die Anschlußklemmen 1l und 1k wird die Energiespule 7 angesteuert. Ebenso sind in der Steuereinheit 1 Mittel vorgesehen, die aus der an den Klemmen 1l und 1k anliegendem Signal das interne Taktsignal gewinnen. Die in bisherigen Anordnungen, z.B. gemäß der DE-A-38 10 702 ist der Datenspulenkreis wie bisher phasengeregelt. Hierzu dienen das PLL-Filter mit den externen Bauelementen 19 und 20 sowie der Phasenmeßeingang 1h mit den externen Bauelementen 11 und 12. Verstimmende Einflüsse wirken in vielen Fällen gleichartig auf beide Spulen. Da sich die Oszillatorfrequenz durch die Energiespule 7 und Kapazität 6 ergibt, paßt sie sich der Verstimmung beider Kreise an. Somit braucht der Nachstimmbereich der Datenspule nicht mehr so groß zu sein. Nur die Datenspule 8 muß phasengeregelt werden. Sie kann mit kleinerer Amplitude arbeiten als die Energiespule, dadurch ist der Einfluß der Kapazitätsdioden 15 und 16 größer und der erforderliche Stimmbereich leichter erreichbar. Die sonst notwendigen Phasenregelelemente für den Energiekreis der Energiespule 7 fallen weg.

Da der Energiekreis jetzt leichter in der Amplitude geregelt werden kann, kann unter Umständen der in Figur 2 dargestellte Aufwärtswandler insbesondere für den Betrieb in Kraftfahrzeugen verzichtet werden.

Verstimmende Einflüsse im Betrieb, z.B. die Annäherung des mobilen Datenträgers mit seinen beiden Spulen wirken in vielen Fällen gleichartig auf die Resonanzfrequenzen der Energie- und Datenspulen 7, 8. Daher ist der notwendige Abstimmbereich der Datenspule 8 verkleinert. Eine weitere wie zuvor beschriebene Vereinfachung des Lesegeräts gibt sich durch eine Amplitudenregelung der Energiespule, die jetzt einfacher zu realisieren ist, da der Energiekreis nicht mehr phasengeregelt ist. Durch diese Maßnahme entfällt der in Figur 2 dargestellte Aufwärtswandler 21, 22.

## Patentansprüche

1. Daten- und Energieübertragungssystem mit:
- einer stationären Station mit einer Spule zur Datenübertragung (8) und einer Spule zur Energieübertragung (7),
- einer beweglichen Station mit einer Spule zur Datenübertragung und einer Spule zur Energieübertragung,
- wobei die jeweiligen Spulen zur Daten- bzw. Energieübertragung jeweils ein Spulenpaar bilden, deren Spulen jeweils zueinander räumlich gegenüberliegen,
- einer taktgesteuerten Steuereinheit (1) der stationären Station zur Ansteuerung der Energiespule (7) und der Datenspule (8),
**dadurch gekennzeichnet, daß** parallel zur Energiespule der stationären Station eine Kapazität (6) geschaltet ist und die Eigenfrequenz dieses Schwingkreises (6, 7) zur Taktversorgung der Steuereinheit (1) dient.

2. Daten- und Energieübertragungssystem nach Anspruch 1, **dadurch gekennzeichnet, daß** ein Aufwärtswandler (21, 22) vorgesehen ist, dessen Ausgangsspannung einem Mittelabgriff der Daten- (8) und der Energieübertragungsspule (7) zugeführt wird.

## Claims

1. Data and power transmission system having:
- a stationary station having a coil for data transmission (8) and a coil for power transmission (7),
- a mobile station having a coil for data transmission and a coil for power transmission,
- with the respective coils for data transmission and power transmission each forming a pair of coils whose coils are each physically opposite one another,
- a clock-controlled control unit (1) in the stationary station for driving the power coil (7) and the data coil (8),
**characterized in that** a capacitance (6) is connected in parallel with the power coil in the stationary station, and the natural frequency of this tuned circuit (6,7) is used to supply the clock for the control unit (1).

2. Data and power transmission system according to Claim 1, **characterized in that** a step-up converter (21,22) is provided, whose output voltage is supplied to a centre tap of the data (8) and power (7) transmission coils.

## Revendications

1. Système de transfert de données et d'énergie comportant :
- un poste fixe comportant une bobine pour le transfert (8) de données et une bobine pour le transfert (7) d'énergie,
- un poste mobile comportant une bobine pour le transfert de données et une bobine pour le transfert d'énergie,
- les bobines respectives pour le transfert de données et d'énergie formant chaque fois une paire de bobines dont les bobines se font face l'une à l'autre dans l'espace,
- une unité (1) de commande du poste fixe, qui est commandée par cadence, et qui est destinée à commander la bobine (7) d'énergie et la bobine (8) de données,
**caractérisé en ce qu'**une capacité (6) est montée en parallèle à la bobine d'énergie du poste fixe et **en ce que** la fréquence propre de ces circuits (6, 7) oscillants sert à l'alimentation en cadence de l'unité (1) de commande.

2. Système de transfert de données et d'énergie suivant la revendication 1, **caractérisé en ce qu'**il est prévu un convertisseur (21, 22) élévateur de tension, dont la tension de sortie est envoyée à une prise médiane de la bobine (8) de transfert de données et de la bobine (7) de transfert d'énergie.
